**Europäisches Patentamt**

**European Patent Office**

**Office européen des brevets**

(19)

(11) **EP 1 154 289 A1**

(12) **EUROPÄISCHE PATENTANMELDUNG**

(43) Veröffentlichungstag:
**14.11.2001 Patentblatt 2001/46**

(51) Int Cl.⁷: **G02B 5/08**, F21V 7/22

(21) Anmeldenummer: **00810397.0**

(22) Anmeldetag: **09.05.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder: **Alcan Technology & Management AG**
**8212 Neuhausen am Rheinfall (CH)**

(72) Erfinder:
- **Krämer, Thomas**
  **31073 Grünenplan (DE)**
- **Gillich, Volkmar**
  **8212 Neuhausen (CH)**
- **Fuchs, Roman**
  **8200 Schaffhausen (CH)**

(54) **Reflektor**

(57)   Die Erfindung betrifft einen Witterungs- und korrosionsbeständiger Reflektor mit hoher Gesamtreflexion im sichtbaren und infraroten Wellenlängenbereich, welcher einen Reflektorkörper mit einer reflektierenden Oberfläche aus Aluminium oder einer Aluminiumlegierung bzw. einen Reflektorkörper mit einer Reflexionsbeschichtung aus Aluminium oder einer Aluminiumlegierung enthält. Der Reflektor enthält ferner eine aussen liegende, abschliessende transparente Schutzschicht aus einem Sol-Gel-Lack einer Dicke von grösser als 1 μm. Der transparente Sol-Gel-Lack ist ein Polymer aus vernetzten anorganischen Siloxanen mit über eine Kohlenstoffbindung mit dem Silizium verbundenen Alkylgruppen. Der Sol-Gel-Lack wird in einem Sol-Gel-Verfahren hergestellt und nach Auftrag auf den Reflektorkörper unter Wärmeeinfluss getrocknet und ausgehärtet. Die Schutzschicht zeichnet sich durch ihre ausgezeichnete Witterungs- und Korrosions- sowie Abriebbeständigkeit aus.

**Fig. 1**

EP 1 154 289 A1

**Beschreibung**

Vorliegende Erfindung betrifft einen Witterungs- und korrosionsbeständigen Reflektor für elektromagnetische Strahlung, insbesondere für Infrarot-Strahlung, sichtbares Licht und Ultraviolett-Strahlung, mit hoher Gesamtreflexion, enthaltend einen Reflektorkörper aus Aluminium oder einer Aluminiumlegierung mit einer reflektierenden Oberfläche oder enthaltend einen Reflektorkörper mit einer eine reflektierende Oberfläche ausbildenden Reflexionsschicht aus Aluminium oder einer Aluminiumlegierung, sowie ein Verfahren zur Herstellung eines erfindungsgemässen Reflektors.

Es ist allgemein bekannt, Bänder in Glänzwerkstoffen, z.B. Reinaluminium, Reinstaluminium oder AlMg-Legierungen auf Basis von Aluminium mit einem Reinheitsgrad von 99,5% und grösser, wie z.B. 99,8%, die je nach Anwendung diffuse oder gerichtete Lichtreflexion erzeugen, herzustellen. Es ist auch bekannt, zur Erhöhung der gerichteten Reflexion die Oberflächen von solchen Bändern chemisch oder elektrolytisch zu glänzen und anschliessend durch anodische Oxidation eine Schutzschicht von z.B. 2 - 10 μm Schichtdicke zu erzeugen.

Solche Reflektoren weisen jedoch in der freien Bewitterung eine beschränkte Lebensdauer aus. Feuchtigkeit im Zusammenwirken mit UV-Strahlung oder $CO_2$, $SO_2$ oder Schadstoffen allgemein führen zur Reduktion der Reflexionswerte, das heisst zur Reduktion des Glanzes bzw. der Gesamtreflexion.

Der Anodisationsprozess und die verhältnismässig hohe Schichtdicke der Anodisationsschicht von beispielsweise 2 - 10 μm führen zudem insbesondere bei weniger reinen Aluminiumwerkstoffen zu einer Herabsetzung des Reflexionsgrades an der Oberfläche, d.h. zu einer Herabsetzung sowohl der Gesamtreflexion wie auch der gerichteten Reflexion durch Absorption und diffuse Lichtstreuung in der Oxidschicht. Um die vorgenannten Nachteile in Grenzen zu halten, müssen deshalb hochreine und teure Glänzlegierungen auf Basis von Reinstaluminium eingesetzt werden. Hochreine Aluminiumwerkstoffe weisen jedoch vielfach ein ungenügendes Umformverhalten und tiefe Streckgrenzen auf, d.h. ihre Festigkeit ist relativ gering.

Bekannt sind auch Reflektoren aus rückseitig mit Aluminium oder Silber verspiegelten Glasflächen. Solche Reflektoren sind jedoch in ihrer Fertigung teuer. Sie weisen zudem ein hohes Gewicht auf, sind zerbrechlich und nicht verformbar.

Aufgabe vorliegender Erfindung ist es, einen Reflektor vorzuschlagen, dessen reflektierende Seite witterungs- und korrosionsbeständig sowie gegen mechanische Einflüsse beständig und ferner gut zu reinigen ist. Überdies soll die Herstellung in einem kontinuierlichen Fertigungsverfahren möglich sein.

Erfindungsgemäss wird die Aufgabe dadurch gelöst, dass die reflektierende Oberfläche aus Aluminium oder einer Aluminiumlegierung eine Rauhigkeit Ra von kleiner als 0,1 μm nach DIN 4761 bis 4768 aufweist und der Reflektor eine aussen liegende, abschliessende transparente Schutzschicht aus einem Polymer einer Dicke von grösser als 1 μm enthält und der Reflektor gemäss 2000h QUV-Test nach ASTM G 53-96 Einbussen in der Gesamtreflexion und im Glanz von weniger als 5% aufweist.

Unter transparenter Schutzschicht ist insbesondere eine klare, farblose, durchsichtige Schutzschicht zu verstehen. Die Schutzschicht ist vorzugsweise ein Sol-Gel-Lack, insbesondere ein Sol-Gel-Lack aus einem Polysiloxan und vorteilhaft ein Sol-Gel-Lack aus einem aus einer alkoholischen Silan-Lösung und einer wässrigen kolloidalen Kieselsäure-Lösung hergestellten Polysiloxan. Polysiloxan ist dabei der Begriff für Polymere aus vernetzten Siloxanen.

Die reflektierende Oberfläche kann durch eine auf den Reflektorkörper aufgetragene metallische Reflexionsschicht oder bevorzugt durch die Reflektorkörperoberfläche selbst ausgebildet sein.

Der Reflektorkörper besteht aus oder weist wenigstens eine freie Oberfläche, insbesondere eine Beschichtung, aus einem Metall, insbesondere aus Aluminium oder einer Aluminiumlegierung, wie z.B. Aluminium mit einer Reinheit von 98,3% und höher, auf. Der Reflektorkörper besteht aus oder weist wenigstens eine freie Oberfläche, insbesondere eine Beschichtung, vorteilhaft aus Aluminium mit einer Reinheit von 99,0% und höher, fallweise auch mit einer Reinheit von 99,5% und höher, vorzugsweise jedoch mit einer Reinheit von 99,7% und höher, und insbesondere von 99,8% und höher, auf. Neben Aluminium genannter Reinheiten können bevorzugt auch Aluminiumlegierungen eingesetzt werden. Bevorzugte Legierungen sind diejenigen der Klassen AA 1000, AA 3000 und AA 5000. Weitere anwendbare Legierungen enthalten beispielsweise 0,25 bis 5 Gew.-%, insbesondere 0,5 bis 4 Gew.-%, Magnesium oder enthalten 0,2 bis 2 Gew.-% Mangan oder enthalten 0,5 bis 5 Gew.-% Magnesium und 0,2 bis 2 Gew.-% Mangan, insbesondere 1 Gew.-% Magnesium und 0,5 Gew.-% Mangan oder enthalten 0,1 bis 12 Gew.-%, vorzugsweise 0,1 bis 5 Gew.-%, Kupfer oder enthalten 0,5 bis 6 Gew.-% Zink und 0,5 bis 5 Gew.-% Magnesium oder enthalten 0,5 bis 6 Gew.-% Zink, 0,5 bis 5 Gew.-% Magnesium und 0,5 bis 5 Gew.-% Kupfer oder enthalten 0,5 bis 2 Gew.-% Eisen und 0,2 bis 2 Gew.-% Mangan, insbesondere 1,5 Gew.-% Eisen und 0,4 Gew.-% Mangan oder AlMgSi-Legierungen oder AlFeSi-Legierungen. Weitere Beispiele sind AlMgCu-Legierungen, wie Al99,85Mg0,8Cu oder AlMg-Legierungen, wie AlMg1, oder AlFeMn-Legierungen wie AlFeMn1,5.

Der Reflektorkörper ist bevorzugt ein Walzprodukt und insbesondere ein gewalztes Blech, oder Band, eine gewalzte Folie oder Platte aus walzbarem Aluminium oder einer walzbaren Aluminiumlegierung. Der Reflektorkörper als Walzprodukt kann gegebenenfalls z.B. durch Biegen, Tiefziehen, Kaltfliesspressen und dgl. umgeformt sein.

Ferner können als Reflektorkörper alle räumlichen Gebilde, die wenigstens eine freie Oberfläche aus einem vorgenannten Aluminium oder einer der vorgenannten Aluminiumlegierungen enthalten oder die vollständig daraus bestehen, zur Anwendung gelangen. Es können auch nur Teilbereiche oder begrenzte Oberflächenbereiche des Reflektorkörpers aus den vorgenannten Aluminiumwerkstoffen oder Aluminiumlegierungen bestehen. Weiters können die genannten räumlichen Gebilde Profile oder Balken sein.

Ferner können die Reflektorkörper auch Guss- oder Schmiedeteile aus Aluminium oder einer Aluminiumlegierung sein.

Je nach Einsatzzweck kann der ganze Reflektorkörper aus Aluminium oder einer Aluminiumlegierung sein, es können aber auch nur Teilbereiche oder Oberflächenbereiche daraus bestehen. Das Material aus Aluminium oder der Aluminiumlegierung, z.B. in der Ausführung eines Bleches, einer Folie oder Platte oder einer Beschichtung, kann auch Teil oder Teiloberfläche eines Verbundes darstellen, z.B. eines Folienverbundes oder Laminates beliebiger Werkstoffe, wie z.B. aus Kunststoffen und Aluminium, wie Al-beschichteter Kunststoff, oder Al-beschichtetes Eisen- oder Stahlblech.

Die Reflektorkörperoberfläche, d.h. die Aluminiumoberfläche des Reflektorkörpers, kann beispielsweise durch chemische und/oder mechanische Veränderung, wie z.B. Walzen, Schmieden, Kaltfliesspressen, Pressen oder Giessen erzeugt werden. Die reflexionswirksame Oberfläche des Reflektorkörpers kann zusätzlich einer Nachbehandlung durch Schleifen, Polieren, Strahlen mit Hartstoffen usw. unterzogen werden. Bevorzugt sind Reflektorkörper mit Walzoberflächen, die mit glatten oder strukturierten Walzen erzeugt werden.

Bevorzugt als Reflektorkörper sind Bleche und Bänder, insbesondere gewalzte Bleche und Bänder aus Aluminium oder einer Aluminiumlegierung der vorgenannten Beschaffenheit sowie Aluminium-beschichtetes Eisen- oder Stahlblech mit einer Dicke von beispielsweise 0,1 bis 10 mm, vorzugsweise 1 bis 4 mm, insbesondere 0,2 bis 1,5 mm und besonders bevorzugt 0,3 - 1 mm, wobei die Aluminium-Beschichtung ebenfalls ein Aluminium oder eine Aluminiumlegierung der vorgenannten Beschaffenheit ist. Ein Beispiel ist ein Aluminiumblech Al 99,5 (Reinheit 99,5%) der Dicke von 0,5 mm.

Die Oberfläche des Reflektorkörpers, bzw. die reflektierende Oberfläche, kann vorbehandelt sein und beispielsweise eine Vorbehandlungsschicht aufweisen. Die Vorbehandlungsschicht kann beispielsweise eine durch Chromatierung, Phosphatierung oder durch anodische Oxidation erzeugte Schicht sein. Vorzugsweise ist die Vorbehandlungsschicht aus anodisch oxidiertem Aluminium und wird insbesondere direkt aus dem an der Oberfläche des Reflektorkörpers liegenden Aluminium erzeugt.

Die Vorbehandlungsschicht kann eine Dicke von beispielsweise wenigstens 10 nm, vorzugsweise von wenigstens 20 nm, insbesondere von wenigstens 50 nm und vorteilhaft von wenigstens 100 nm aufweisen. Die maximale Dicke der Vorbehandlungsschicht beträgt beispielsweise 5000 nm, vorzugsweise 1500 nm und insbesondere 300 nm.

Die Vorbehandlungsschicht ist bevorzugt eine anodisch erzeugte Oxidschicht, die in einem nicht rücklösenden und vorzugsweise in einem rücklösenden Elektrolyten aufgebaut wurde. Die Vorbehandlungsschicht ist vorzugsweise eine poröse, anodisch erzeugte Oxidschicht.

Die Anodisation findet vorzugsweise in einem sauren Elektrolyten aus der Reihe der Phosphorsäure-, Zitronensäure-, Weinsäure-, Chromsäureelektrolyte und insbesondere aus der Reihe der Schwefelsäureelektrolyte statt. Die Anodisation erfolgt im Wechsel- und vorzugsweise im Gleichstromverfahren. Es ist Stückanodisieren, wie auch Bandanodisieren möglich.

Die anodische erzeugte Oxidschicht kann ferner einer Sealing- resp. Verdichtungsbehandlung unterzogen werden. Die genannte Oxidschicht ist vorzugsweise nicht verdichtet.

Die Vorbehandlungschicht kann auch eine Gelbchromatierschicht, eine Grünchromatierschicht, eine Phosphatschicht oder eine chromfreie Vorbehandlungsschicht, die in einem Elektrolyten, enthaltend wenigstens eines der Elemente Ti, Zr, F, Mo oder Mn, aufgewachsen ist, enthalten.

Ferner kann die Aluminiumoberfläche zur Vorbehandlung in einem chemischen oder elektrochemischen Verfahren geglänzt sein oder einem alkalischen Beizprozess unterzogen sein. Solche Glänz- oder Beizverfahren werden vor dem Anodisieren durchgeführt.

Vor dem Auftrag einer Vorbehandlungsschicht oder Durchführung erster Vorbehandlungsschritte wird die Reflektoroberfläche zweckmässig entfettet und gereinigt. Die Vorbehandlung kann auch lediglich ein Entfetten und Reinigen der Reflektoroberfläche beinhalten. Die Reinigung der Oberfläche kann auf an sich bekannte Weise, z.B. chemisch und/oder elektrochemisch und sauer oder alkalisch, erfolgen. Sie bezweckt die Entfernung von Fremdsubstanzen und gegebenenfalls der natürlich entstanden Oxidschicht auf der Aluminiumoberfläche. Als Reinigungsmittel eignen sich z.B. saure, wässrige Entfettungsmittel, alkalische Entfettungsmittel auf der Basis von Polyphosphat und Borat. Eine Reinigung mit mässigem bis starkem Materialabtrag bildet das Beizen oder Aetzen mittels stark alkalischen oder sauren Beizlösungen, wie z.B. Natronlauge oder ein Gemisch aus Salpetersäure und Flusssäure. Dabei wird die vorhandene Oxidschicht mitsamt seinen Verunreinigungen entfernt. Bei stark angreifenden alkalischen Beizen ist gegebenenfalls eine saure Nachbehandlung notwendig.

Je nach Oberflächenzustand ist auch ein mechanischer Oberflächenabtrag durch abrasive Mittel notwendig. Eine solche Oberflächenvorbehandlung kann beispielsweise durch Schleifen, Strahlen, Bürsten oder Polieren geschehen und gegebenenfalls durch eine chemische Nachbehandlung ergänzt werden.

In einer bevorzugten Ausführung wird in einem Bandverfahren eine Vorbehandlungsschicht auf ein Aluminiumband aufgebracht. Dazu wird ein Aluminiumband (Al 99,85, Ra 0,04 μm) mit 500 mm Breite und 0,3 mm Dicke kontinuierlich bei rund 40 m/min anodisiert. Dabei wurden folgende Stufen durchlaufen (durchlaufene Bäder):

a) Entfettung bei pH 9 - 9,5, bei ca. 50° C und Bonder V6150/01,
b) Spülen mit Leitungswasser (Raumtemperatur),
c) Anodisieren in 20% $H_2SO_4$ bei ca. 25°C und 20V Spannung,
d) Spülen in Leitungswasser bei ca. 50°C und
e) Spülen in entionisiertem Wasser bei ca. 85°C.

Auf die Vorbehandlungsschicht können anschliessend die Schutzschicht oder weitere Schichten aufgebracht werden. Das Band wird vorteilhaft erst nach Abschluss der Beschichtung, d.h. nach Beschichtung mit der Schutzschicht, in Bänder von gewünschter Grösse und Form aufgeteilt.

Die reflektierende Oberfläche weist eine Rauhigkeit Ra von zweckmässig weniger als 0,1 μm, vorzugsweise von weniger als 0,05 μm und insbesondere von weniger als 0,02 μm auf. Die Oberflächenrauhigkeit Ra ist definiert in wenigstens einer der DIN-Vorschriften 4761 bis 4768.

Die Oberfläche des Reflektorkörpers kann glatt oder strukturiert sein und beispielsweise eine lichtleitende Struktur in der Ausprägung von z.B. eines Rippenmusters mit zahnförmigem Querschnitt aufweisen. Die Strukturierung kann z.B. über eine Walze mit entsprechendem Prägemuster erzeugt sein. Die Oberfläche des Reflektorkörpers kann bezüglich Strukturierung oder Rauhigkeit derart beschaffen sein, das die Reflexion der Strahlung gerichtet, gestreut oder eine Kombination davon ist.

Die vorgenannte Rauhigkeit Ra von strukturierten Oberflächen soll sich auf die einzelnen Teilflächen der Oberflächenstruktur beziehen, d.h. die Strukturierung selbst soll sinngemäss nicht in die Bestimmung der Rauhigkeit miteinbezogen sein.

In einer weiteren Ausführung kann auf den Reflektorkörper bzw. auf dessen Vorbehandlungsschicht eine die reflektierende Oberfläche ausbildende Reflexionsschicht aus einem Metall, wie z.B. eine Schicht aus Aluminium, Silber, Kupfer, Gold, Chrom, Nickel oder aus einer Legierungen, beispielsweise enthaltend überwiegend wenigstens eines der genannten Metalle, aufgetragen sein. Die Dicke der Reflexionsschicht kann beispielsweise 10 bis 200 nm (Nanometer) betragen. Ferner kann auf den Reflektorkörper bzw. auf dessen Vorbehandlungsschicht zur Einebnung der Oberflächenrauhigkeit eine funktionelle Schicht in der Ausführung einer organischen oder anorganischen Sol-Gel-Schicht aufgebracht sein. Die Reflexionsschicht kommt hier in der Regel direkt, oder über eine Haftschicht, auf die funktionelle Schicht zu liegen. Die Beschaffenheit der funktionellen Schicht ist in EP 918 236 A1 ausführlich beschrieben.

Die Reflexionsschicht kann ferner ein Teil eines Reflexionsschichtsystems sein, wobei das Reflexionsschichtsystem eine oder mehrere, auf der Reflexionsschicht aufgebrachten, transparente Schichten enthält. Beispielsweise 1, 2, 3, 4, 5, 6, 7, 8, 9 oder 10 transparente Schichten - gezählt ohne die Schutzschicht -- erfüllen vorteilhaft bezüglich der optischen Dicke für jede Schicht die Formel λ/2, wobei insbesondere jede dieser transparenten Schichten eine Doppelschicht aus jeweils 2 Schichten der Dicke λ/4 ist. Die optische Dicke jeder transparenten Schicht mit der Formel λ/2 kann um ± 40 nm variieren. Bevorzugt ist eine transparente Schicht oder weiter bevorzugt sind zwei, drei oder mehrere transparente Schichten, die aus gleichen oder unterschiedlichen Materialien sein können, wobei jede der transparenten Schichten eine optische Dicke von λ/2 ± 40 nm aufweist und insbesondere eine Doppelschicht der Dicke 2 • λ/4 ist. Auf die genannte transparente Schicht oder Schichten, als oberste Schicht, resp. als die an der Oberfläche liegende Schicht, wird die Schutzschicht, die ihrerseits auch transparent ist, angeordnet. λ entspricht dem Intensitätsmaximum der Wellenlänge der reflektierten elektromagnetischen Strahlung.

Die Materialien der transparenten Schichten des Reflexionsschichtsystems bestehen aus oder enthalten z. B. Oxide, Nitride, Fluoride, Sulfide usw. von Alkalimetallen, z.B. Li, Na, K, Erdalkalimetallen, z.B. Mg, Ca, Sr, Ba, Halbmetallen, wie z.B. Si, Übergangsmetallen, z.B. Sc, Ti, V, Cr,Mn, Fe, Co, Ni, Y, Zr, Nb, Mo, Te, Ru,Rh, Pd, Hf, Ta, W, Re, Os, Ir ,Pt, Lanthanoiden, z.B. La, Ce, Pr, Nd, Pm, Dy, Yb, Lu usw. Es können namentlich genannt werden $SiO_x$, wobei x die Bedeutung von 1,1 bis 2,0 und vorzugsweise 1,8 hat, $Al_2O_3$, $MgF_2$, $TiO_2$, $B_2O_3$, Be-Oxid, ZnO, $SnO_2$, Indium-Zinn-Oxid (ITO), CdS, CdTe und Hafnium- und Zirkon-Oxide. Vorteilhaft weisen wenigstens eine der transparenten Schichten, mit Ausnahme der Schutzschicht, andere Materialien auf, als die Schutzschicht selbst.

Alle oder einzelne Schichten des Reflexionsschichtsystems sowie die Reflexionsschicht können beispielsweise durch Gas- oder Dampfphasenabscheidung im Vakuum, (physical vapor deposition, PVD), durch thermische Verdampfung, durch Elektronenstrahlverdampfung, mit und ohne Ionenunterstützung, durch Sputtern, insbesondere durch Magnetronsputtering, durch Plasmapolymerisation oder durch chemische Gasphasenabscheidung (chemical vapor deposition, CVD) mit und ohne Plasmaunterstützung, auf den Reflektorkörper, resp. auf eine darauf befindliche Vorbehandlungsschicht, aufgebracht werden. Andere Auftragungsverfahren sind Lackier- oder Tauchziehverfahren von im Sol-Gel-Prozess hergestellten Lösungen mit anschliessender Trocknung, flammpyrolytische Verfahren oder Flammbeschichtung mittels $SiO_2$. Es können auch zwei oder mehrere Verfahren kombiniert werden. Es können z.B. PVD-Schichten durch eine Flammbeschichtung mit $SiO_2$ ergänzt werden. Die genannten Reflexionsschichtsysteme sind beispielsweise in EP 918 236 A1 ausführlich beschrieben.

Die Schutzschicht ist zweckmässig ein auf die Reflektorkörperoberfläche, die Vorbehandlungsschicht oder gegebenenfalls auf die Reflexionsschicht bzw. auf ein Reflexionsschichtsystem aufgetragener Sol-Gel-Lack, welcher nach einem Sol-Gel-Verfahren hergestellt und auf den Reflektorkörper aufgetragen wird.

Der Sol-Gel-Lack ist bevorzugt ein aus einer alkoholischen Silan-Lösung, insbesondere Alkoxysilan-Lösung und einer kollodialen Kieselsäure-Lösung hergestelltes Polysiloxan. Das Polysiloxan wird insbesondere durch eine Kondensationsreaktion zwischen hydrolisierten und vernetzbaren Silanen, insbesondere Alkoxysilanen, und kolloidaler Kieselsäure erzeugt.

Die Kondensationsreaktion zwischen hydrolisierten Silanen, insbesondere Alkoxysilanen, untereinander sowie hydrolisierten Silanen, insbesondere Alkoxysilanen, und kolloidaler Kieselsäure führt zur Ausbildung eines anorganischen Netzwerkes von Polysiloxanen. Gleichzeitig werden organische Gruppen, insbesondere Alkylgruppen bzw. einfache Alkylgruppen über Kohlenstoffbindungen in das anorganische Netzwerk eingebaut. Die organischen Gruppen, bzw. die Alkyl-Gruppen, nehmen jedoch nicht direkt an der Polymerisation bzw. der Vernetzung der Siloxane teil, d.h. sie dienen nicht zur Ausbildung eines organischen Polymersystems sondern lediglich zur Funktionalisierung. Die Funktion liegt darin, dass die organischen Gruppen, insbesondere die Alkyl-Gruppen, während des Sol-Gel-Prozesses an den Aussenseiten der Polysiloxane angehängt werden und dadurch eine gegen aussen wasserabstossende Lage ausbilden, welche dem Sol-Gel-Lack eine ausgeprägte hydrophobe Eigenschaft verleiht.

Der beschriebene Sol-Gel-Prozess führt, wie erwähnt, durch gezielte Hydrolyse und Kondensation von Alkoxiden des Siliziums und Kieselsäure zu einem Sol-Gel-Lack aus einem anorganischen Netzwerk mit eingebauten Alkylgruppen. Die dadurch erhaltenen Polysiloxane sind deshalb eher den anorganischen Polymeren einzuordnen.

Bei der Herstellung einer bevorzugten Ausführung eines Sol-Gel-Lackes als Schutzschichtwird zweckmässig von zwei Basislösungen A und B ausgegangen.

Die **Lösung A** ist eine alkoholische Lösung eines oder mehrerer verschiedener Alkoxysilane, wobei die Alkoxysilane in einem wasserfreien Medium in nicht hydrolisierter Form vorliegen. Als Lösungsmittel wird zweckmässig ein Alkohol, wie beispielsweise Methyl-, Ethyl-, Propyl- oder Butylalkohol und bevorzugt Isopropylalkohol, verwendet.

Die Alkoxysilane werden durch die allgemeine Formel $X_nSi(OR)_{4-n}$ beschrieben, in welcher "R" ein einfaches Alkyl ist, vorzugsweise aus der Gruppe umfassend Methyl, Ethyl, Propyl und Buthyl. "X" ist zweckmässig ebenfalls ein Alkyl, vorzugsweise aus der Gruppe umfassend Methyl, Ethyl, Propyl und Buthyl. Zweckmässige Alkoxysilane sind beispielsweise Tetramethoxysilane (TMOS) und bevorzugt Tetraethoxysilan (TEOS) und Methyltrimethoxysilan (MTMOS) und weitere Alkoxysilane.

In besonders bevorzugter Ausführungsform wird die Lösung A aus Tetraethoxysilan (TEOS) und/oder Methyltrimethoxysilan (MTMOS) mit einem Methyl-, Ethyl- oder Propyl-Alkohol und insbesondere mit einem Isopropylalkohol als Lösungsmittel zubereitet. Die Lösung A kann z.B. 25 - 35 Gew.-% (Gewichts-%), insbesondere 30 Gew.-%, TEOS und 15 - 25 Gew.-%, insbesondere 20 Gew.-%, MTMOS enthalten, beides gelöst in 40 - 60 Gew.-%, insbesondere 50 Gew.-%, Isopropylalkohol.

Die **Lösung B** enthält in Wasser gelöste kolloidale Kieselsäure. In zweckmässiger Ausführung wird die Lösung B mittels Säure, vorzugsweise mittels Salpetersäure ($HNO_3$), auf einen pH-Wert zwischen 2,0 - 4, vorzugsweise zwischen 2,5 - 3,0 und insbesondere von 2,7 eingestellt.

Die verwendete Kieselsäure ist zweckmässig eine in saurem Milieu stabilisierte Kieselsäure, wobei der pH-Wert der Kieselsäure vorteilhaft bei 2 - 4 liegt. Die Kieselsäure ist vorteilhaft möglichst alkaliarm. Der Alakaligehalt (z. B. $Na_2O$) der Kieselsäure liegt bevorzugt unter 0,04 Gew.-%.

Die Lösung B enthält beispielsweise 70 - 80 Gew.-%, insbesondere 75 Gew.-%, Wasser als Lösungsmittel und 20 - 30 Gew.-%, insbesondere 25 Gew.-%, kolloidale Kieselsäure. Die Lösung B ist zweckmässig mittels Salpetersäure ($HNO_3$) auf einen pH-Wert zwischen 2,0 - 3,5, vorzugsweise zwischen 2,5 - 3,0, und insbesondere von 2,7 eingestellt. Eine bevorzugte Kieselsäure-Lösung wird beispielsweise durch die Firma Nissan Chemical Industries Ltd. mit dem Produktname "SNOWTEX® O" vertrieben.

Das Zusammenführen und Mischen der beiden Basislösungen A und B führt in Gegenwart der Salpetersäure zu einer Hydrolysereaktion zwischen dem in Lösung B enthaltenen Wasser und den in Lösung A enthaltenen Alkoxysilanen.

Hydrolyse-Reaktion: $Si(OR)_n + nH_2O \rightarrow Si(OH)_n + nR(OH)$

Gleichzeitig tritt eine Kondensationsreaktion ein, bei der unter Wasser-Abspaltung aus jeweils zwei Si-OH-Gruppen eine Siloxan-Bindung (Si-O-Si) aufgebaut wird. Durch fortschreitende Polymerisation entsteht dabei ein Netzwerk von Polysiloxanen, an welche Alkyl-Gruppen angegliedert sind. Die neue Mischlösung liegt in einem gelförmigen Zustand vor.

Die beiden Lösungen A und B werden bevorzugt in einem Gewichts-Verhältnis von 7 : 3 Teilen gemischt.

Der Sol-Gel-Lack wird zweckmässig in Gel-Form auf den Reflektorkörper, bzw. auf die entsprechende Oberfläche, aufgetragen bzw. abgeschieden und anschliessend getrocknet bzw. gehärtet. Der Trocknungsprozess besteht darin, die im Sol-Gel-Lack verbleibenden Wasser und Alkohole auszutreiben, wodurch der Sol-Gel-Lack aushärtet und eine witterungsbeständige und korrosionsfeste Schutzschicht auf der Reflektoroberfläche bzw. der Reflexionsschicht entsteht.

Die Beschichtung erfolgt zweckmässig in einem kontinuierlichen Verfahren, durch beispielsweise Aufpinseln, Aufwalzen, Schleudern, Spritzen Tauchen bzw. Tauchziehbeschichten. Besonders bevorzugte kontinuierliche Beschichtungsverfahren sind das Banddurchlaufverfahren oder Bandlackierungsverfahren, auch Coil-Coating-Verfahren genannt.

Die Schichtdicke des ausgehärteten Sol-Gel-Lackes beträgt beispielsweise wenigstens 1 um, vorzugsweise wenigstens 2 um, und beispielsweise höchstens 40 μm, vorzugsweise höchstens 20 μm, insbesondere höchstens 10 μm, und vorteilhaft höchstens 6 μm.

Der mit dem Sol-Gel-Lack beschichtete Reflektor wird zweckmässig mittels Strahlung, wie UV-Strahlung, Elektronenstrahlung, Laserstrahlung, oder mittels Wärmestrahlung, wie IR-Strahlung, oder mittels Konvektionserwärmung oder einer Kombination der vorgenannten Trockungs- bzw. Härtungsverfahren, getrocknet resp. gehärtet.

Die erhöhte Temperatur, gemessen am Reflektorkörper, zur Trockung bzw. Härtung des Sol-Gel-Lackes ist zweckmässig grösser als 60° C, vorzugsweise grösser als 150° C und insbesondere grösser als 200° C. Die erhöhte Temperatur ist ferner zweckmässig kleiner als 400°C, vorzugsweise kleiner als 350°C und insbesondere kleiner als 300°. Die erhöhte Temperatur liegt besonders bevorzugt zwischen 250°C und 300°C. Bei der Temperaturangabe handelt es sich um eine sogenannte "Peak Metal Temperature" (PMT).

Die erhöhte Temperatur kann beispielsweise während 5 Sekunden bis 2 Minuten auf den Körper einwirken. Der Sol-Gel-Lack wird während einer Zeit von vorzugsweise weniger als 90 Sekunden, insbesondere von weniger als 60 Sekunden, und von vorzugsweise mehr als 10 Sekunden, insbesondere von mehr als 30 Sekunden getrocknet bzw. gehärtet. Bei Einsatz von IR-Strahlung liegen die Trockungszeiten eher im unteren Bereich der angegebenen Aufenthaltszeiten.

Die Konvektionserwärmung kann zweckmässig durch eine Beaufschlagung mit erwärmten Gasen, wie Luft, Stickstoff, Edelgase oder Gemischen daraus, erfolgen. Die Sol-Gel-Lackschicht wird bevorzugt in einem Durchlaufofen getrocknet.

Die Reflektoren, beispielsweise in Form von Folien, Bändern oder Blechen, lassen sich nach dem Auftrag und Trocknung der Schutzschicht auch umformen. Die Reflektoren könne z.B. zu Parabolwannen weiterverarbeitet werden. Die Umformung führt dabei kaum zu Rissbildung in der Schutzschicht.

Die Reflektoren gemäss Erfindung weisen eine gute Schutzwirkung gegen Witterungseinflüsse, Korrosion, mechanischen Abbau oder Abrieb bzw. weisen eine hohe Kratzfestigkeit auf. Kreidung tritt praktisch keine auf. Da bei der Herstellung der Siloxane kolloidale Kieselsäure verwendet wird, lassen sich grössere Schichtdicken im Mikrometerbereich herstellen, bei welchen während des Trocknungs- und Härtungsprozesses keine Rissbildung, z.B. aufgrund Volumenkontraktion, entsteht.

Ferner erlauben die erfindungsgemässen Reflektoren den Einsatz von Aluminiumlegierungen, ohne dass diese zwecks Erreichen hoher Glanz- und Gesamtreflexionswerte z.B. mit Rein- oder Reinstaluminium plattiert bzw. beschichtet werden müssen. Im Gegensatz zu den Reflektoren aus Rein- oder Reinstaluminium, weisen Letztere jedoch wesentlich höhere Festigkeiten auf, was für verschiedenste Anwendungen unabdingbar ist.

Der Reflektor weist eine Gesamtreflexion nach DIN 5036 3. Teil, insbesondere eine Gesamtreflexion im sichtbaren und infraroten Wellenlängenbereich, von grösser als 75%, vorzugsweise von grösser als 80%, und insbesondere von grösser als 83%, auf.

Enthält der Reflektor ein zusätzliches reflexionserhöhendes Schichtsystem, beträgt die genannte Gesamtreflexion über 75%, vorzugsweise über 85%, und insbesondere über 90%.

Der Reflektor weist ferner Glanzwerte im sichtbaren Wellenlängenbereich nach DIN 67530 von über 75%, insbesondere von über 80% auf.

Die genannte Gesamtreflexion und der Glanz des erfindungsgemässen Reflektors nimmt beispielsweise nach 3000h (Stunden) QUV-Test und insbesondere nach 2000h QUV-Test um weniger als 5%, und insbesondere um weniger als 2% ab.

Der QUV-Test ist ein künstlicher Bewitterungstest zur Beurteilung der Witterungsbeständigkeit von Bauteilen und ihren Oberflächen im Freien. Der QUV-Test wurde 1969 durch das Unternehmen "Q-Panel" eingeführt und ist heute eine international standardisierte Testmethode. Der in vorliegenden Versuchen angewendete QUV-Test wurde gemäss den Vorgaben nach "Standard Practice for Operating Light- and Water-Exposure Apparatus (Fluorescent UV-Condensation Type) for Exposure of Nonmetallic Materials" der American Society for Testing and Materials", bzw. nach ASTM G 53-96, ausgeführt.

Der erfindungsgemässe Reflektor weist ferner im 1000h "Filiformkorrosionstest" nach DIN EN ISO 3665, keine Korrosionserscheinungen auf. Überdies beträgt die Abnahme der Gesamtreflexion und des Glanzes im 1000h "Essigsaure Salzsprühtest" nach DIN 50021 ESS weniger als 5%, insbesondere weniger als 2%.

Des weiteren verfügen die erfindungsgemässen Reflektoren dank der Sol-Gel-Schutzschicht aus Polysiloxanen über eine hohe Oberflächenhärte. Die Sol-Gel-Schutzschicht weist zweckmässig eine Härte gemessen nach der Methode "Bleistiftverfahren nach Wolf Wilburn" nach DIN 55350 Teil 18 von grösser "f", vorzugsweise von grösser "h", insbesondere von grösser "2h" und vorteilhaft von grösser "3h" auf, wobei grösser im Sinne von härter zu verstehen ist.

Die Sol-Gel-Schicht zeichnet sich zudem durch eine ausgezeichnete Haftung auf dem Reflektorkörper bzw. auf den darüberliegenden Schichten aus.

Der erfindungsgemässe Reflektor ist herstellbar dadurch, die reflektierende Oberfläche aus Aluminium oder einer Aluminiumlegierung eine Rauhigkeit Ra von kleiner als 0,1 μm nach DIN 4761 bis 4768 aufweist und der Reflektor eine aussen liegende, abschliessende transparente Schutzschicht aus einem Polymer einer Dicke von grösser als 1 μm enthält und die Schutzschicht in einem kontinuierlichen Coil-Coating-Verfahren auf die reflektierende Oberfläche, die Vorbehandlungsschicht oder das Reflexionsschichtsystem aufgetragen wird und die Schutzschicht des Reflektors in einem Durchlaufofen getrocknet und gehärtet wird.

Die Bandbeschichtungsgeschwindigkeit in einem Banddurchlaufverfahren beträgt beispielsweise rund 30m/min.

Der Reflektorkörper wird vorzugsweise in einem Durchlaufofen unter Einwirkung von Wärmestrahlung und/oder Konvektionswärme, vorzugsweise unter Beaufschlagung mit erwärmten Gasen getrocknet.

Die Beschichtung erfolgt zweckmässig bei Raumtemperatur, z.B. bei 10 - 30 °C, insbesondere bei 15 - 25 °C.

Vorliegende Erfindung umfasst auch die Verwendung erfindungsgemässer Reflektoren als Reflektoren für Sonnen- oder Kunstlicht und Infrarotstrahlung und als Lichtleitelemente für Sonnen- oder Kunstlicht.

Die erfindungsgemässen Reflektoren sind beispielsweise geeignet als Reflektoren oder Lichtleitelemente in der Licht- und Leuchtentechnik, wie Reflektoren in Bildschirmarbeitsplatz-Leuchten, Primärleuchten, Sekundärleuchten, Rasterleuchten, Lichtdecken oder als Lichtumlenklamellen. Ferner können die erfindungsgemässen Reflektoren in der Solartechnik als Solar-Reflektoren, z.B. in der thermischen Solartechnik, als Solar Booster im Bereich der Photovoltaik, in Solar-Kraftwerken, als lichtkonzentrierende Sonnenkollektoren, in Solar-Kocher oder Solar-Öfen, eingesetzt werden.

Ferner können die erfindungsgemässen Reflektoren als leichte, unzerbrechliche und gegebenenfalls beheizbare Spiegel für Fahrzeuge oder als Scheinwerferreflektoren eingesetzt werden. Die besagten Reflektoren können auch als Fassadenelemente mit reflektierenden Eigenschaften bzw. mit Glanzeigenschaften eingesetzt werden. Die beispielsweise hoch- oder mattglänzenden Aluminiumoberflächen sind dabei dank der erfindungsgemässen Schutzschicht korrosionsfest versiegelt.

Die IR-Strahlung, das sichtbare Licht und die UV-Strahlung decken dabei den Wellenlängenbereich von $10^{-8}$ m bis $10^{-3}$ m ab.

Nachfolgend wird anhand eines Beispiels die Zubereitung und Herstellung einer besonders bevorzugten Ausführung eines Sol-Gel-Lackes beschrieben. Dazu werden eine Lösung A und eine Lösung B vorbereitet:

| Lösung A enthält: | |
|---|---|
| 50 Gew.-% | Isopropylalkohol |
| 30 Gew.-% | Tetraethoxysilan (TEOS) |
| 20 Gew.-% | Methyltrimethoxysilan (MTMOS) |

| Lösung B enthält: | |
|---|---|
| 75 Gew.-% | Wasser |
| 25 Gew.-% | Kolloidale Kieselsäure |

Der pH-Wert der Lösung B ist unter Zugabe einer Säure, insbesondere Salpetersäure ($HNO_3$), auf ca. 2,7 eingestellt.

Die Herstellung des Sol-Gel-Lackes und die Beschichtung des Reflektorkörpers erfolgt in bevorzugter Ausführung wie folgt:

Einer Basislösung A, wie zuvor beschrieben, in einem Anteil von 70 Gew.-% der Mischlösung wird unter Rühren eine Lösung B in einem Anteil von 30 Gew.-% der Mischlösung zugegeben. Die Lösungen A und B werden unter kontinuierlichem Rühren in eine Mischlösung überführt, wobei reaktionsbedingt Wärme freigesetzt wird.

Die Mischlösung wird über eine bestimmte Zeit, beispielsweise während 1 h (Stunde) bis 10 h, vorzugsweise währen 4 bis 8 h, insbesondere während rund 6 h gerührt.

Das Gemisch wird anschliessend filtriert. Der Filter dient dem Rückhalt grösserer Partikel, wie z.B. Partikel von kollodialer Kieselsäure. Der Porendurchmesser bzw. die Maschenweite des Filters richtet sich nach der angestrebten Schichtdicke, da Partikel mit grösserem Durchmesser als die angestrebte Schichtdicke die Oberflächenqualität der Schutzschicht beeinträchtigen. Die Filtration kann beispielsweise mittels Polypropylenfilter mit einer Porosität von 1 μm erfolgen.

Die Mischlösung wird zweckmässig auf einem pH-Wert von 2 - 4, vorzugsweise von 2 bis 3,5, insbesondere von 2,5 bis 3, und besonders bevorzugt von 2,7, gehalten. Die Angleichung des pH-Wertes erfolgt mittels Säure, bevorzugt mittels Salpetersäure.

Nach Abschluss des Rührvorganges kann der Sol-Gel-Lack mittels eines der vorgenannten Verfahrens auf den Reflektorkörper oder die darüber liegenden Schichten aufgetragen und nachfolgend, wie vorgängig beschrieben, getrocknet bzw. gehärtet werden.

In vorteilhafter Ausführung des Herstellungsverfahrens wird der Sol-Gel-Lack nach seiner Herstellung und vor dem Auftrag auf den Reflektorkörper während weniger Minuten bis mehreren Stunden, vorzugsweise zwischen 1 und 24 h (Stunden), insbesondere zwischen 12 und 22 h und besonders bevorzugt während rund 17 h ruhig gestellt.

Die Elementanalyse des ausgehärteten Sol-Gel-Lackes mittels XPS (X-Ray Photoelectron Spectroscopy) weist z.B. die Elemente Sauerstoff, Silizium und rund 5 - 20% (Atomprozente) Kohlenstoff nach.

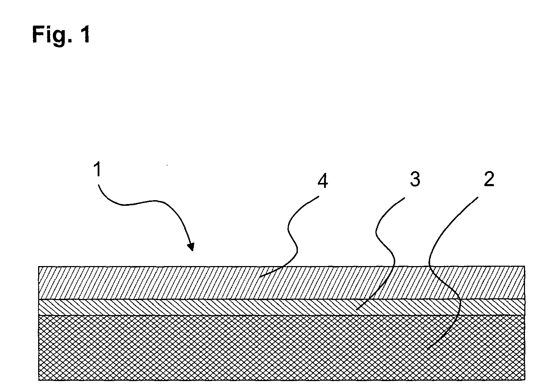

Der Aufbau eines erfindungsgemässen Reflektors ist beispielhaft anhand der Figur 1 dargestellt, welche eine Querschnittsansicht durch einen erfindungsgemässen Reflektor zeigt.

Der Reflektor (1) besteht aus einem Reflektorkörper (2), welcher ein Walzprodukt aus Aluminium mit einem Reinheitsgrad von grösser 99,8% ist. Die Oberfläche des Reflektorkörpers (2) ist entfettet und mit einer Vorbehandlungsschicht (3) versehen. Die Vorbehandlungsschicht (3) ist eine anodisch erzeugte Oxidschicht mit einer Dicke von 300 - 500 nm. Auf die Vorbehandlungsschicht ist eine Sol-Gel-Lackschicht (4) von 3 μm Dicke aus Polysiloxanen aufgebracht.


**Patentansprüche**

1. Witterungs- und korrosionsbeständiger Reflektor (1) für elektromagnetische Strahlung, insbesondere für Infrarot-Strahlung, sichtbares Licht und Ultraviolett-Strahlung, mit hoher Gesamtreflexion, enthaltend einen Reflektorkörper (2) aus Aluminium oder einer Aluminiumlegierung mit einer reflektierenden Oberfläche oder enthaltend einen Reflektorkörper mit einer eine reflektierende Oberfläche ausbildenden Reflexionsschicht aus Aluminium oder einer Aluminiumlegierung,

   **dadurch gekennzeichnet, dass**
   die reflektierende Oberfläche aus Aluminium oder einer Aluminiumlegierung eine Rauhigkeit Ra von kleiner als 0,1 μm nach DIN 4761 bis 4768 aufweist und der Reflektor (1) eine aussen liegende, abschliessende transparente Schutzschicht (4) aus einem Polymer einer Dicke von grösser als 1 μm enthält und der Reflektor gemäss 2000h QUV-Test nach ASTM G 53-96 Einbussen in der Gesamtreflexion und im Glanz von weniger als 5% aufweist.

2. Reflektor nach Anspruch 1, **dadurch gekennzeichnet, dass** die Schutzschicht (4) ein Sol-Gel-Lack, vorzugsweise ein Sol-Gel-Lack aus einem Polysiloxan, insbesondere ein Sol-Gel-Lack aus einem aus einer alkoholischen Silan-Lösung, vorzugsweise einer Alkoxysilan-Lösung, und einer wässrigen kolloidalen Kieselsäure-Lösung hergestelltes Polysiloxan, ist.

3. Reflektor nach einem der Ansprüche 1 bis 2, **dadurch gekennzeichnet, dass** die transparente Schutzschicht ein Sol-Gel-Lack aus vernetzten anorganischen Polysiloxanen mit über Kohlenstoffbindungen mit dem Silizium verbundenen organischen Gruppen, insbesondere Alkylgruppen, ist.

4. Reflektor nach einem der Ansprüche 1 bis 3, **dadurch gekennzeichnet, dass** der Reflektor eine Gesamtreflexion, insbesondere eine Gesamtreflexion im sichtbaren und infraroten Wellenlängenbereich, nach DIN 5036 von grösser als 75%, vorzugsweise von grösser als 80%, und insbesondere von grösser als 83%, aufweist.

5. Reflektor nach einem der Ansprüche 1 bis 4, **dadurch gekennzeichnet, dass** der Reflektor im 1000h "Filiformkorrosionstest" nach DIN EN ISO 3665 keine Korrosionserscheinungen aufweist und im 1000h "Essigsauren Salzsprühtest" nach DIN 50021 ESS eine Abnahme der Gesamtreflexion und des Glanzes von weniger als 5%, insbesondere von weniger als 2% aufweist.

**6.** Reflektor nach einem der Ansprüche 1 bis 5, **dadurch gekennzeichnet, dass** die Schutzschicht (4) eine Härte, gemessen nach der Methode "Bleistiftverfahren nach Wolf Wilburn" nach DIN 55350 Teil 18, von grösser "f", vorzugsweise von grösser "h", insbesondere von grösser "2h" und vorteilhaft von grösser "3h" aufweist.

**7.** Reflektor nach einem der Ansprüche 1 bis 6, **dadurch gekennzeichnet, dass** die Schutzschicht im gehärteten Zustand eine Dicke von wenigstens 1 µm, vorzugsweise wenigstens 2 µm, und von höchstens 40 µm, vorzugsweise höchstens 20 µm, insbesondere höchstens 10 µm, aufweist.

**8.** Reflektor nach einem der Ansprüche 1 bis 7, **dadurch gekennzeichnet, dass** der Reflektor einen Reflektorkörper aus Aluminium und/oder eine Beschichtung aus Aluminium enthält und der Aluminiumwerkstoff des Reflektorkörpers und/oder der Beschichtung einen Reinheitsgrad von grösser als 99,5%, vorzugsweise grösser als 99,7% und insbesondere grösser als 99,8% aufweist.

**9.** Reflektor nach einem der Ansprüche 1 bis 8, **dadurch gekennzeichnet, dass** die reflektierende Oberfläche, vorzugsweise die Reflektorkörperoberfläche, eine Vorbehandlungsschicht (3) aufweist und die Vorbehandlungsschicht (3) eine in einem rücklösenden oder nicht rücklösenden Elektrolyten anodisch erzeugte Oxidschicht, vorzugsweise eine in einem rücklösenden Elektrolyten anodisch erzeugte poröse Oxidschicht, insbesondere eine unverdichtete, poröse Oxidschicht, ist und die Schutzschicht (4) unmittelbar auf die Oxidschicht aufgetragen ist.

**10.** Reflektor nach einem der Ansprüche 1 bis 9, **dadurch gekennzeichnet, dass** auf die reflektierende Oberfläche des Reflektors eine durch Chromatierung oder Phosphatierung erzeugte Vorbehandlungsschicht aufgebracht ist und die Schutzschicht (4) unmittelbar auf die Vorbehandlungsschicht aufgebracht ist.

**11.** Reflektor nach einem der Ansprüche 1 bis 10, **dadurch gekennzeichnet, dass** auf die reflektierende Oberfläche des Reflektors eine Vorbehandlungsschicht aufgebracht ist und die Vorbehandlungsschicht eine Gelbchromatierschicht, eine Grünchromatierschicht, eine Phosphatschicht oder eine chromfreie Vorbehandlungsschicht ist, die in einem Elektrolyten, enthaltend wenigstens eines der Elemente Ti, Zr, F, Mo oder Mn, aufgewachsen ist.

**12.** Reflektor nach einem der Ansprüche 9 bis 11, **dadurch gekennzeichnet, dass** die Vorbehandlungsschicht eine Dicke von wenigstens 10 nm, vorzugsweise von wenigstens 20 nm und insbesondere von wenigstens 50 nm und besonders bevorzugt von wenigsten 100 nm und eine Dicke von maximal 5000 nm, vorzugsweise von maximal 500 nm aufweist.

**13.** Reflektor nach einem der Ansprüche 1 bis 12, **dadurch gekennzeichnet, dass** der Reflektorkörper ein Walzprodukt, insbesondere ein Blech, Band oder eine Platte, aus einem walzbaren Aluminium oder Aluminiumlegierung ist unddie Rauhigkeit Ra der reflektierenden Oberfläche kleiner als 0,05 µm ist.

**14.** Reflektor nach einem der Ansprüche 1 bis 13, **dadurch gekennzeichnet, dass** der Reflektorkörper ein gewalztes Blech oder Band aus Aluminium oder einer Aluminiumlegierung mit einer Dicke von 0,1 bis 4 mm, bevorzugt von 0,2 bis 1,5 mm und insbesondere von 0,3 bis 1 mm ist.

**15.** Reflektor nach einem der Ansprüche 1 bis 14, **dadurch gekennzeichnet, dass** die Schutzschicht (4) auf die Reflektorkörperoberfläche oder auf dessen Vorbehandlungsschicht aufgetragen ist.

**16.** Reflektor nach einem der Ansprüche 1 bis 15, **dadurch gekennzeichnet, dass** der Reflektor einen Reflektorkörper aus Aluminium, einer Aluminiumlegierung, aus einem Eisenmetall oder aus Kunststoff mit einer Reflexionsschicht aus Aluminium oder einer Aluminiumlegierung enthält und die Schutzschicht auf die Reflexionsschicht aufgetragen ist.

**17.** Reflektor nach einem der Ansprüche 1 bis 16, **dadurch gekennzeichnet, dass** der Reflektorkörper ein Reflexionsschichtsystem aus einer reflektierenden Schicht und einem reflexionserhöhendem Schichtsystem mit einer oder mehreren auf die reflektierende Schicht aufgebrachten, transparenten Schichten enthält und die abschliessende Schutzschicht auf das Reflexionsschichtsystem aufgebracht ist.

**18.** Reflektor nach Anspruch 17, **dadurch gekennzeichnet, dass** der Reflektor eine Gesamtreflexion, insbesondere eine Gesamtreflexion im sichtbaren und infraroten Wellenlängenbereich, nach DIN 5036 von grösser als 75%, vorzugsweise von grösser als 85%, und insbesondere von grösser als 90%, aufweist.

**19.** Verfahren zur Herstellung eines Witterungs- und korrosionsbeständigen Reflektors (1) für elektromagnetische Strahlung, insbesondere für Infrarot-Strahlung, sichtbares Licht und Ultraviolett-Strahlung, mit hoher Gesamtreflexion, enthaltend einen Reflektorkörper (2) aus Aluminium oder einer Aluminiumlegierung mit einer reflektierenden Oberfläche oder enthaltend einen Reflektorkörper mit einer Reflexionsschicht aus Aluminium oder einer Aluminiumlegierung, nach Anspruch 1,
**dadurch gekennzeichnet, dass**
die reflektierende Oberfläche aus Aluminium oder einer Aluminiumlegierung eine Rauhigkeit Ra von kleiner als 0,1 μm nach DIN 4761 bis 4768 aufweist und der Reflektor (1) eine aussen liegende, abschliessende transparente Schutzschicht (4) aus einem Polymer einer Dicke von grösser als 1 Um enthält und die Schutzschicht (4) in einem kontinuierlichen Coil-Coating-Verfahren auf die reflektierende Oberfläche, die Vorbehandlungsschicht oder das Reflexionsschichtsystem aufgetragen wird und die Schutzschicht (4) des Reflektors (1) in einem Durchlaufofen getrocknet und gehärtet wird.

**20.** Verfahren nach Anspruch 16, **dadurch gekennzeichnet, dass** der Reflektorkörper bei Raumtemperatur mit der Schutzschicht beschichtet wird und die Schutzschicht des Reflektors in einem Durchlaufofen unter Einwirkung von Wärmestrahlung und/oder Konvektionswärme, vorzugsweise unter Beaufschlagung mit erwärmten Gasen getrocknet wird.

**21.** Verfahren nach einem der Ansprüche 19 bis 20, **dadurch gekennzeichnet, dass** die Schutzschicht des Reflektors bei einer Temperatur des Reflektors zwischen 110 und 400° C, vorzugsweise zwischen 200 und 350°C und insbesondere zwischen 250 und 300°C während einer Zeit von weniger als 90 Sekunden, vorzugsweise weniger als 60 Sekunden, getrocknet wird.

**22.** Verwendung der Reflektoren nach Anspruch 1 als Reflektoren für Sonnen- oder Kunstlicht und Infrarotstrahlung und als Lichtleitelemente für Sonnen- oder Kunstlicht.

**23.** Verwendung der Reflektoren nach Anspruch 22 in der Licht- und Leuchtentechnik als Reflektoren in Bildschirmarbeitsplatz-Leuchten, Primärleuchten, Sekundärleuchten, Rasterleuchten, Lichtdecken oder als Lichtumlenklamellen und in der Solartechnik als Solar-Reflektoren in Solar-Kraftwerken, Solar-Kocher oder Solar-Öfen.

**Fig. 1**

**Europäisches Patentamt**

# EUROPÄISCHER RECHERCHENBERICHT

Nummer der Anmeldung

EP 00 81 0397

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 985 046 A (HINDS PAULA A ET AL) 16. November 1999 (1999-11-16)<br><br>* Spalte 1, Zeile 22 - Zeile 26 *<br>* Spalte 1, Zeile 53 - Zeile 60 *<br>* Spalte 2, Zeile 6 - Zeile 32 *<br>* Spalte 3, Zeile 9 - Zeile 58 *<br>* Spalte 4, Zeile 38 - Zeile 39 *<br>--- | 1,4,7, 13-15, 19-21 | G02B5/08 F21V7/22 |
| X | US 5 478 414 A (BOMBALSKI ROBERT E ET AL) 26. Dezember 1995 (1995-12-26)<br>* Spalte 1, Zeile 44 - Zeile 60 *<br>* Spalte 4, Zeile 11 - Zeile 25 *<br>* Spalte 5, Zeile 37 - Zeile 44 *<br>* Spalte 8, Zeile 11 - Zeile 28 *<br>* Spalte 9, Zeile 21 - Zeile 28 *<br>* Spalte 13, Zeile 19 - Zeile 22 *<br>--- | 1,7,13, 14,19 | |
| X | DE 298 12 559 U (ALANOD ALUMINIUM VEREDLUNG GMB) 25. November 1999 (1999-11-25)<br>* Seite 3, Absatz 2 *<br>* Seite 4, Absatz 2 - Seite 5, Absatz 3; Abbildung 1 *<br>* Seite 7, Absatz 4 *<br>* Seite 8, letzter Absatz - Seite 9, letzter Absatz *<br>---<br><br>-/-- | 1-4,9, 14-19, 22,23 | **RECHERCHIERTE SACHGEBIETE (Int.Cl.7)**<br><br>G02B F21V |

Der vorliegende Recherchenbericht wurde für alle Patentansprüche erstellt

| Recherchenort | Abschlußdatum der Recherche | Prüfer |
|---|---|---|
| BERLIN | 2. November 2000 | Ciarrocca, M |

# EP 1 154 289 A1

**Europäisches Patentamt**

## EUROPÄISCHER RECHERCHENBERICHT

Nummer der Anmeldung

EP 00 81 0397

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | PATENT ABSTRACTS OF JAPAN vol. 018, no. 142 (P-1706), 9. März 1994 (1994-03-09) -& JP 05 323107 A (MATSUSHITA ELECTRIC WORKS LTD), 7. Dezember 1993 (1993-12-07) * Zusammenfassung * -& DATABASE WPI Section Ch, Week 199402 Derwent Publications Ltd., London, GB; Class A89, AN 1994-013336 XP002151850 * Zusammenfassung * --- | 1,4,7, 16,19-21 | |
| X | WO 91 16197 A (CARDINAL IG COMPANY) 31. Oktober 1991 (1991-10-31) * Seite 5, letzter Absatz - Seite 6, Zeile 9 * * Seite 8, Absatz 2; Abbildung 2 * * Seite 15, Zeile 4 - Zeile 10 * --- | 1,5,7, 16,19 | |
| A | EP 0 816 875 A (ALUSUISSE LONZA SERVICES AG) 7. Januar 1998 (1998-01-07) <br><br> * Zusammenfassung * * Seite 3, Zeile 22 - Zeile 38 * * Seite 4, Zeile 10 - Zeile 32 * * Seite 5, Zeile 6 - Zeile 8 * * Seite 5, Zeile 27 - Zeile 28 * * Seite 7, Zeile 40 - Zeile 44 * * Seite 8, Zeile 5 - Zeile 25; Tabelle 1 * --- <br><br> -/-- | 1-4,8,9, 13-15, 19,22,23 | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| BERLIN | 2. November 2000 | Ciarrocca, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

| | Europäisches Patentamt | EUROPÄISCHER RECHERCHENBERICHT | Nummer der Anmeldung EP 00 81 0397 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | EP 0 824 154 A (ALUSUISSE LONZA SERVICES AG) 18. Februar 1998 (1998-02-18)<br><br>* Spalte 3, Zeile 36 - Spalte 4, Zeile 35 *<br><br>* Spalte 7, Zeile 54 - Spalte 8, Zeile 38 *<br><br>* Spalte 9, Zeile 56 - Spalte 10, Zeile 57 *<br><br>* Spalte 12, Zeile 26 - Zeile 30 *<br>* Spalte 14, Zeile 13 - Zeile 53; Abbildung 1 *<br>--- | 1-4, 7-14, 17-23 | |
| A | EP 0 568 943 A (ALUMINUM CO OF AMERICA) 10. November 1993 (1993-11-10)<br>* Spalte 1, Zeile 34 - Spalte 2, Zeile 18 *<br>----- | 1,2,13, 19 | |
| | | | **RECHERCHIERTE SACHGEBIETE (Int.Cl.7)** |

Der vorliegende Recherchenbericht wurde für alle Patentansprüche erstellt

| Recherchenort | Abschlußdatum der Recherche | Prüfer |
|---|---|---|
| BERLIN | 2. November 2000 | Ciarrocca, M |

**ANHANG ZUM EUROPÄISCHEN RECHERCHENBERICHT
ÜBER DIE EUROPÄISCHE PATENTANMELDUNG NR.**          EP 00 81 0397

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

02-11-2000

| Im Recherchenbericht angeführtes Patentdokument | Datum der Veröffentlichung | Mitglied(er) der Patentfamilie | Datum der Veröffentlichung |
|---|---|---|---|
| US 5985046 A | 16-11-1999 | US 5725683 A | 10-03-1998 |
| US 5478414 A | 26-12-1995 | US 5290424 A<br>US 5637404 A<br>US 5955147 A | 01-03-1994<br>10-06-1997<br>21-09-1999 |
| DE 29812559 U | 25-11-1999 | KEINE | |
| JP 05323107 A | 07-12-1993 | KEINE | |
| WO 9116197 A | 31-10-1991 | CA 2081341 A<br>US 5215832 A | 26-10-1991<br>01-06-1993 |
| EP 0816875 A | 07-01-1998 | AU 710729 B<br>AU 2473297 A<br>CA 2208302 A<br>JP 10068805 A<br>US 6067189 A<br>US 5978133 A | 30-09-1999<br>15-01-1998<br>28-12-1997<br>10-03-1998<br>23-05-2000<br>02-11-1999 |
| EP 0824154 A | 18-02-1998 | AU 3246597 A<br>CA 2212833 A<br>JP 10090505 A<br>NO 973736 A<br>US 5919561 A | 19-02-1998<br>15-02-1998<br>10-04-1998<br>16-02-1998<br>06-07-1999 |
| EP 0568943 A | 10-11-1993 | KEINE | |

EPO FORM P0461

Für nähere Einzelheiten zu diesem Anhang : siehe Amtsblatt des Europäischen Patentamts, Nr.12/82